# DEMANDE DE BREVET EUROPEEN

(11) **EP 4 651 327 A1**
(43) Date de publication de la demande: **19.11.2025**
(21) Numéro de dépôt: 25176884.2
(22) Date de dépôt: 16.05.2025
(51) Int. Cl.: H02H 1/00, H02H 3/08, G01R 31/327, G06N 20/00, G06N 5/01

(54) **PROCÉDÉ D'ESTIMATION D'UNE INTENSITÉ DE DÉCLENCHEMENT D'UN DISJONCTEUR, SYSTÈME, ENSEMBLE, ET PROGRAMME D'ORDINATEUR ASSOCIÉS**

(30) Priorité: 17.05.2024 FR 2405090
(71) Demandeur: SCHNEIDER ELECTRIC INDUSTRIES SAS, 92500 Rueil-Malmaison (FR)
(72) Inventeur: LANES, David, 38660 SAINT HILAIRE DU TOUVET (FR); WENZEL, Nicolas, 38100 GRENOBLE (FR)
(74) Mandataire: Lavoix

(57) **Abrégé**

La présente invention concerne un procédé d'estimation d'une intensité de déclenchement d'un disjoncteur, le disjoncteur étant configuré pour basculer d'une configuration armée, à une configuration déclenchée, un courant de déclenchement, d'intensité égale à l'intensité de déclenchement, circulant dans le disjoncteur lorsqu'il bascule dans la configuration déclenchée, le basculement du disjoncteur dans la configuration déclenchée générant un son, représentatif de l'intensité de déclenchement, le procédé comprenant au moins les étapes suivantes :
- acquisition (102) d'un signal de sortie (Sₒ) émis par un microphone, le signal de sortie étant représentatif du son généré par le disjoncteur lorsqu'il bascule dans la configuration déclenchée ;
- calcul (108) d'une pluralité de métriques à partir du signal de sortie (Sₒ) ; et
- détermination (110) d'une classe d'intensité de déclenchement via un modèle d'intelligence artificielle, la classe d'intensité de déclenchement étant choisie parmi une pluralité de classes d'intensité de déclenchement prédéterminées.

## Description

La présente invention concerne un procédé d'estimation d'une intensité de déclenchement d'un disjoncteur, un système, un ensemble, et un programme d'ordinateur associés.

Afin de surveiller le fonctionnement d'un disjoncteur et de prévoir des opérations de maintenance prédictives, il est connu de mesurer l'intensité du courant qui circule au travers du disjoncteur au moment où le disjoncteur bascule en configuration déclenchée, c'est-à-dire devient isolant électriquement. Le courant qui circule au travers du disjoncteur au moment où le disjoncteur bascule en configuration déclenchée est appelé courant de déclenchement, et a une intensité dite intensité de déclenchement.

Cependant la mesure de l'intensité de déclenchement est coûteuse et intrusive, puisqu'elle nécessite d'ajouter un capteur d'intensité à l'intérieur du disjoncteur, plus précisément sur l'un des conducteurs du disjoncteur, ce capteur devant être capable de résister aux intensités de déclenchement dont les valeurs peuvent être élevées.

Le but de l'invention est alors de proposer un procédé et un système de détection permettant d'estimer l'intensité de déclenchement de manière simple, non intrusive et à faible coût.

A cet effet, l'invention a pour objet un procédé d'estimation d'une intensité de déclenchement d'un disjoncteur, le disjoncteur étant apte à être connecté entre une source et une charge, le disjoncteur étant configuré pour basculer d'une configuration armée, dans laquelle le disjoncteur conduit un courant circulant entre la source et la charge, à une configuration déclenchée, dans laquelle le disjoncteur isole électriquement la charge de la source, un courant de déclenchement, d'intensité égale à l'intensité de déclenchement, circulant dans le disjoncteur lorsqu'il bascule dans la configuration déclenchée, le basculement du disjoncteur dans la configuration déclenchée générant un son, représentatif de l'intensité de déclenchement, le procédé comprenant au moins les étapes suivantes, mises en œuvre par un module électronique de contrôle :
- acquisition d'un signal de sortie émis par un microphone, le signal de sortie étant représentatif du son généré par le disjoncteur lorsqu'il bascule dans la configuration déclenchée ;
- calcul d'une pluralité de métriques à partir du signal de sortie ; et
- détermination d'une classe d'intensité de déclenchement via un modèle d'intelligence artificielle, préalablement entraîné par apprentissage automatique pour fournir, à partir de la pluralité de métriques, la classe d'intensité de déclenchement associée au courant de déclenchement, la classe d'intensité de déclenchement étant choisie parmi une pluralité de classes d'intensité de déclenchement prédéterminées, chaque classe d'intensité de déclenchement correspondant à une plage d'intensité de déclenchement.

Grâce à l'invention, l'estimation de l'intensité est simplifiée. En effet, l'utilisation du son pour déterminer l'intensité de déclenchement ne nécessite pas de mesures complexes ou intrusives, par exemple à l'intérieur du disjoncteur, ou sur des contacts du disjoncteur. Le procédé est ainsi facile à mettre en œuvre et non intrusif. De plus, l'utilisation d'un modèle d'intelligence artificielle permet de simplifier la détermination de l'intensité de déclenchement par rapport à des méthodes traditionnelles d'analyse et de traitement du signal et ainsi, de limiter la complexité du procédé.

Suivant d'autres aspects avantageux de l'invention, le procédé comprend une ou plusieurs des caractéristiques suivantes, prises isolément ou suivant toutes les combinaisons techniquement possibles :
- Le procédé comprend en outre une étape de filtrage du signal de sortie.
- Le procédé comprend en outre une étape de normalisation pour normaliser en amplitude le signal de sortie.
- Le calcul de la pluralité de métriques comprend le calcul d'une pluralité de coefficients cepstraux sur l'échelle Mel à partir du signal de sortie.
- La pluralité de classes d'intensité de déclenchement est formée de cinq classes d'intensité de déclenchement, chaque classe d'intensité de déclenchement correspondant à une plage d'intensité de déclenchement distincte des autres classes d'intensité de déclenchement.
- Le modèle d'intelligence artificielle est une forêt aléatoire.
- Le procédé comprend en outre une étape de transmission de la classe d'intensité de déclenchement déterminée à un module d'émission.
- Le procédé comprend en outre une étape d'attribution d'une classe d'intensité de déclenchement dite maximale au courant de déclenchement si le microphone sature lors de l'acquisition du son.

L'invention concerne également un système d'estimation d'une intensité de déclenchement d'un disjoncteur, le disjoncteur étant apte à être connecté entre une source et une charge, le disjoncteur étant configuré pour basculer d'une configuration armée, dans laquelle le disjoncteur conduit un courant circulant entre la source et la charge, à une configuration déclenchée, dans laquelle le disjoncteur isole électriquement la charge de la source, un courant de déclenchement d'intensité l'intensité de déclenchement circulant dans le disjoncteur lorsqu'il bascule dans la configuration déclenchée, le basculement du disjoncteur dans la configuration déclenchée générant un son, représentatif de l'intensité de déclenchement, le système comprenant :
- un microphone, configuré pour acquérir le son généré par le disjoncteur lorsqu'il bascule dans la configuration déclenchée et pour émettre un signal de sortie, le signal de sortie étant représentatif du son ;
- un module électronique de contrôle, configuré pour recevoir le signal de sortie, le module électronique de contrôle comprenant :
   o une unité de calcul configurée pour calculer une pluralité de métriques à partir du signal de sortie ; et
   o une unité de détermination, configurée pour déterminer une classe d'intensité de déclenchement via un modèle d'intelligence artificielle, préalablement entraîné par apprentissage automatique pour fournir, à partir de la pluralité de métriques, la classe d'intensité de déclenchement associée au courant de déclenchement, la classe d'intensité de déclenchement étant choisie parmi une pluralité de classes d'intensité de déclenchement prédéterminées, chaque classe d'intensité de déclenchement correspondant à une plage d'intensité de déclenchement.

L'invention concerne également un ensemble électrique comprenant :
- un disjoncteur, apte à être connecté entre une source et une charge, le disjoncteur étant configuré pour basculer d'une configuration armée, dans lequel le disjoncteur conduit un courant circulant entre la source et la charge, à une configuration déclenchée, dans lequel le disjoncteur isole électriquement la charge de la source, lorsqu'un courant de déclenchement d'intensité une intensité de déclenchement circule dans le disjoncteur, le basculement du disjoncteur dans la configuration déclenchée générant un son représentatif de l'intensité de déclenchement, le disjoncteur comprenant un boîtier ; et
- un système d'estimation, fixé au boîtier.

L'invention concerne également un programme d'ordinateur comportant des instructions logicielles qui, lorsqu'elles sont exécutées par un microcontrôleur, mettent en œuvre un procédé d'estimation tel que défini ci-dessus.

L'invention apparaîtra plus clairement à la lecture de la description qui va suivre, donnée uniquement à titre d'exemple non limitatif, et faite en référence aux dessins dans lesquels :
- [Fig. 1] la figure 1 est un schéma d'un ensemble électrique selon un mode de réalisation de l'invention ;
- [Fig. 2] la figure 2 est un schéma d'un module électronique de contrôle selon un mode de réalisation de l'invention ;
- [Fig. 3] la figure 3 est un logigramme d'un procédé d'estimation selon un mode de réalisation de l'invention ;
- [Fig. 4] la figure 4 est un graphe d'un signal de sortie.

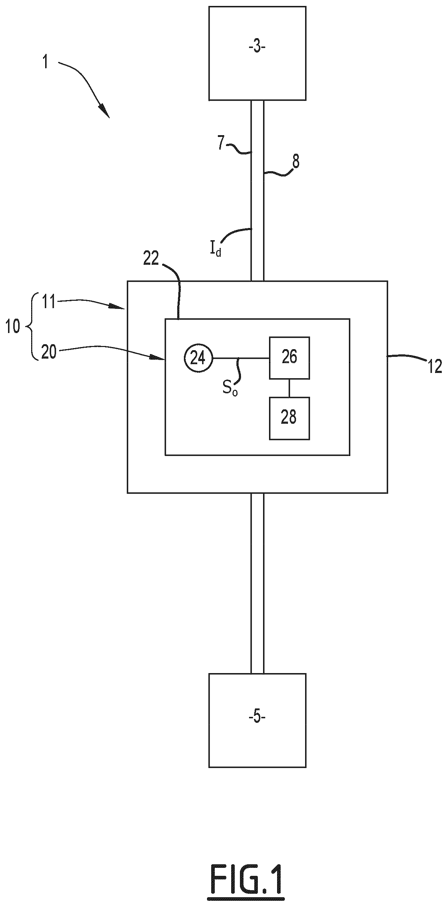

La figure 1 représente une installation électrique 1. L'installation électrique 1 comprend une source 3 et une charge 5, électriquement reliées entre elles par un conducteur de phase 7 et un conducteur de neutre 8. La source 3 fournit de l'électricité et est, par exemple, un générateur électrique, un transformateur ou un réseau électrique, par exemple un réseau électrique de secteur. La charge 5 est un appareil consommant de l'électricité, comme un appareil électrique domestique, un équipement industriel comme un moteur électrique, ou encore un serveur. Un courant électrique, dit simplement courant par la suite, circule entre la source 3 et la charge 5 à travers le conducteur de phase 7 et revient à la source 3 par le conducteur de neutre 8.

Le courant est avantageusement un courant basse tension, c'est-à-dire qu'une tension nominale du courant est inférieure à 1500V. Le courant est un courant alternatif, ou en variante, un courant continu.

L'installation électrique 1 comprend un ensemble électrique 10. L'ensemble électrique 10 comprend un disjoncteur 11, connecté entre la source et la charge. Le disjoncteur 11 est par exemple un disjoncteur à boîtier moulé, ou MCCB, de l'anglais « Molded Case Circuit Breaker ». Le disjoncteur 11 comprend un boîtier 12, qui est dans un matériau isolant électriquement. Le boîtier 12 contient la majorité des autres composants du disjoncteur 11, notamment des contacts du disjoncteur, non représentés.

Le disjoncteur 11 est configuré pour basculer entre une configuration armée, dans laquelle les contacts sont fermés, et dans laquelle il conduit le courant circulant entre la source 3 et la charge 5, et une configuration déclenchée, dans laquelle les contacts sont ouverts et dans laquelle il isole électriquement la source 3 de la charge 5. Le disjoncteur 11 est configuré pour basculer en configuration déclenchée en cas de court-circuit ou de surcharge de l'installation électrique 1, afin d'éviter qu'un courant trop important ne circule dans l'installation électrique 1. Le disjoncteur 11 est également configuré pour basculer en configuration déclenchée suite à une commande de l'utilisateur, par exemple qui le bascule manuellement en configuration déclenchée en actionnant une manette du disjoncteur 11. Lorsque le disjoncteur 11 bascule en configuration déclenchée, le courant circulant dans le disjoncteur 11 est dit courant de déclenchement, qui a une intensité égale à une intensité de déclenchement I_{d}.

L'ensemble électrique 10 comprend en outre un système 20 d'estimation de l'intensité de déclenchement I_{d} du disjoncteur 11. Le système d'estimation 20 est fixé au boîtier 12, par exemple en étant collé ou vissé sur le boîtier 12. De manière avantageuse, le système d'estimation 20 comprend une enveloppe 22 qui est fixée sur le boîtier 12.

Le système d'estimation comprend un microphone 24, un module électronique de contrôle 26, connecté au microphone 24, et un module d'émission 28, connecté au module électronique de contrôle 26, avantageusement logés à l'intérieur de l'enveloppe 22.

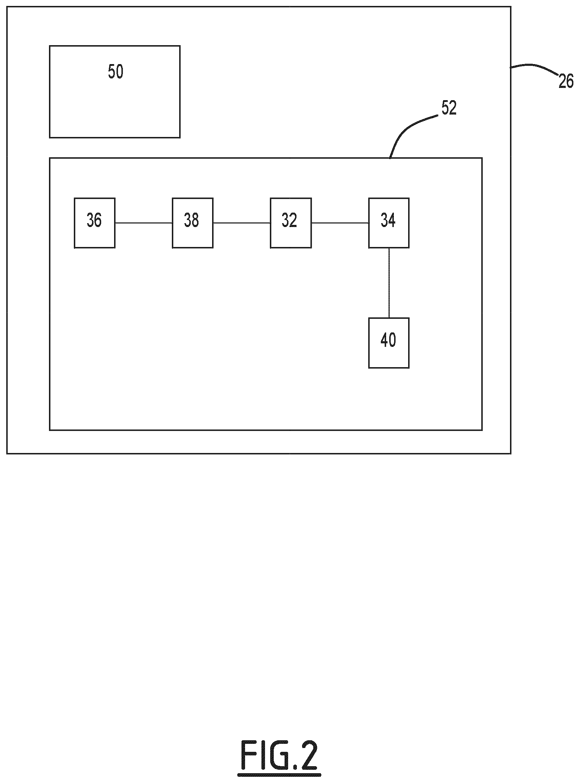

Le module électronique de contrôle 26 comprend une unité de calcul 32 connectée à une unité de détermination 34, comme représenté sur la figure 2. De manière avantageuse, le module électronique de contrôle 26 comprend en outre une unité de filtrage 36, connectée à une unité de normalisation 38, connectée à l'unité de calcul 32. De manière avantageuse, le module électronique de contrôle 26 comprend en outre une unité de transmission 40, connectée à l'unité de détermination 34.

Dans l'exemple de la figure 2, le module électronique de contrôle 26 est formé par exemple d'un processeur 50 et d'une mémoire 52, associée au processeur 50. Dans l'exemple de la figure 2, l'unité de calcul 32 et l'unité de détermination 34, ainsi qu'en complément facultatif l'unité de filtrage 36, l'unité de normalisation 38 et l'unité de transmission 40, sont réalisées chacun sous forme d'un logiciel, ou d'une brique logicielle, exécutable par le processeur 50. La mémoire du module électronique de contrôle 26 est alors apte à stocker un logiciel de calcul et un logiciel de détermination, ainsi qu'en complément facultatif un logiciel de filtrage, un logiciel de normalisation et un logiciel de transmission. Le processeur est alors apte à exécuter chacun des logiciels parmi le logiciel de calcul et le logiciel de détermination, ainsi qu'en complément facultatif le logiciel de filtrage, le logiciel de normalisation et le logiciel de transmission.

En variante non représentée, l'unité de calcul 32 et l'unité de détermination 34, ainsi qu'en complément facultatif l'unité de filtrage 36, l'unité de normalisation 38 et l'unité de transmission 40 sont réalisées chacune sous forme d'un composant logique programmable, tel qu'un FPGA (de l'anglais *Field Programmable Gate Array*), ou encore d'un circuit intégré, tel qu'un ASIC (de l'anglais *Application Specific Integrated Circuit*)*.*

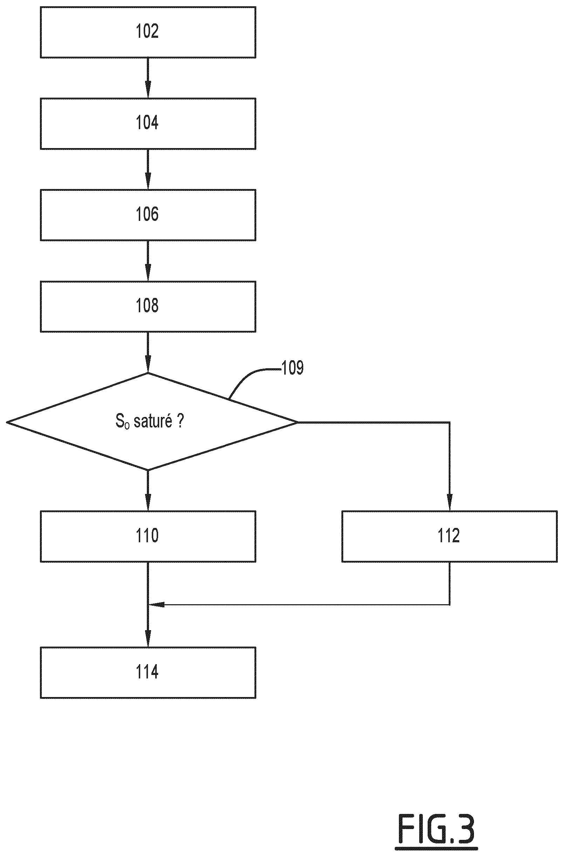

En variante, lorsque le module électronique de contrôle 26 est réalisé sous forme d'un ou plusieurs logiciels, c'est-à-dire sous forme d'un programme informatique, également appelé programme d'ordinateur ou produit programme d'ordinateur, il est en outre apte à être enregistré sur un support, non représenté, lisible par ordinateur, ou encore, par un microcontrôleur. Le support lisible est par exemple un medium apte à mémoriser des instructions électroniques et à être couplé à un bus d'un système informatique. A titre d'exemple, le support lisible est un disque optique, un disque magnéto-optique, une mémoire ROM, une mémoire RAM, tout type de mémoire non-volatile (par exemple FLASH ou NVRAM) ou une carte magnétique. Sur le support lisible est alors mémorisé un programme d'ordinateur comprenant des instructions logicielles, qui, lorsqu'elles sont exécutées par un microcontrôleur, mettent en œuvre un procédé d'estimation de l'intensité de déclenchement I_{d} du disjoncteur 11 décrit en détail ci-dessous, et en référence à la figure 3.

Lorsque le disjoncteur 11 bascule dans la configuration déclenchée, il génère un son. Par son, il est entendu des vibrations mécaniques qui se propagent dans l'air, et non pas dans un milieu solide, comme le boîtier 12. Le son est causé par exemple par l'apparition d'un arc électrique entre les contacts au moment de leur ouverture, puis par la dissipation de cet arc, ainsi que par le mouvement des contacts du disjoncteur 11. Dans le cas d'une ouverture par l'utilisateur sans courant dans les contacts du disjoncteur 11, le son est causé uniquement par le mouvement des contacts du disjoncteur 11. Ainsi, le son est représentatif de l'intensité de déclenchement I_{d}.

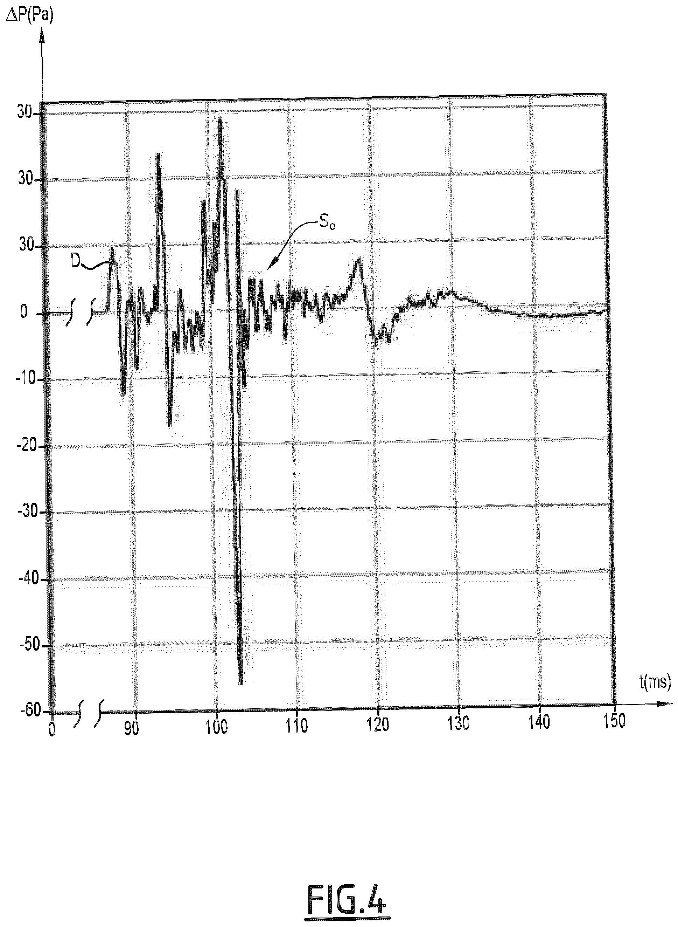

Le microphone 24 acquiert le son généré par le disjoncteur 11 lorsqu'il bascule de la configuration armée à la configuration déclenchée et émet un signal de sortie Sₒ. Le signal de sortie Sₒ, représenté à la figure 4, est représentatif du son généré par le disjoncteur 11, et donc de l'intensité de déclenchement I_{d}.

En pratique, le microphone 24 acquiert le son généré par le disjoncteur en continu et émet de manière continue une grandeur physique, par exemple une tension ou modulation de tension, un courant dont l'amplitude est directement proportionnelle au son acquis par le microphone 24. Tant que le son acquis par le microphone 24 correspond à une variation de pression ΔP strictement inférieure à un seuil de pression, cette grandeur physique ne comprend aucune information relative à l'intensité de déclenchement I_{d}. Le seuil de pression est par exemple égal à 1Pa. Par égal à une valeur, on entend égal cette valeur plus ou moins 1% de cette valeur.

Lorsque le son acquis par le microphone 24 correspond à une variation de pression ΔP supérieure ou égale au seuil de pression, la grandeur physique forme un signal de sortie Sₒ, qui est alors représentatif du son généré par le disjoncteur 11, et donc de l'intensité de déclenchement I_{d}. Le signal de sortie Sₒ comprend un événement de déclenchement D, qui est associé au son correspondant à la variation de pression supérieure ou égale au seuil de pression.

De manière avantageuse, le signal de sortie Sₒ est d'une durée inférieure ou égale à 200ms, par exemple égale à 150ms, centré autour de l'événement de déclenchement. En variante, le signal de sortie Sₒ à une durée égale à 150ms, l'événement de déclenchement étant à 100ms du début du signal de sortie Sₒ.

De manière avantageuse, le signal de sortie Sₒ est échantillonné à une fréquence inférieure ou égale à 30kHz, par exemple égale à 24KHz.

Le procédé d'estimation de l'intensité de déclenchement I_{d} du disjoncteur 11, dont un mode de réalisation est décrit ci-après en référence à la figure 3, met en œuvre une estimation de l'intensité de déclenchement I_{d} à partir du son causé par le déclenchement et capté par le microphone 24. Les étapes du procédé décrit ci-dessous sont mises en œuvre par le module électronique de contrôle 26.

Le module électronique de contrôle 26 acquiert le signal de sortie Sₒ lors d'une étape 102.

Avantageusement, le module électronique de contrôle 26 effectue une étape 104 de filtrage du signal de sortie Sₒ. Par exemple, le module électronique de contrôle 26 effectue un filtrage passe-haut, par exemple avec une fréquence de coupure à 30Hz et un filtrage passe-bas, par exemple avec une fréquence de coupure à 10KHz. L'étape 104 de filtrage est avantageusement mise en œuvre par l'unité de filtrage 36.

Avantageusement, le module électronique de contrôle 26 effectue une étape de normalisation en amplitude 106 du signal de sortie Sₒ. Avantageusement, l'étape 106 est mise en œuvre par l'unité de normalisation 38.

Le module électronique de contrôle 26 calcule une pluralité de métriques à partir du signal de sortie Sₒ, avantageusement filtré et normalisé, à l'étape 108. Plus précisément, l'étape 108 est mise en œuvre par l'unité de calcul 32.

Avantageusement, la pluralité de métriques est une pluralité de coefficients cepstraux sur l'échelle Mel, ou MFCC, de l'anglais « Mel Frequency Cepstral Coefficients ». Par exemple, les MFCC sont calculés sur cinq fenêtres glissantes, 13 MFCC étant calculés pour chaque fenêtre, formant un total de 65 coefficients calculés à partir du signal de sortie Sₒ.

En variante la pluralité de métrique comprend une valeur RMS, de l'anglais Root Mean Square, ou moyenne quadratique du signal de sortie Sₒ, une magnitude du signal de sortie Sₒ, c'est-à-dire le maximum en valeur absolue du signal de sortie Sₒ, une fréquence moyenne du signal de sortie Sₒ. La fréquence moyenne du signal de sortie Sₒ est liée au courant circulant dans le disjoncteur 11, des fréquences élevées étant associées à un faible courant, par exemple inférieur à 250 A, et des basses fréquences étant associées à un courant élevé, par exemple supérieur à 2500 A.

De manière avantageuse, le module électronique de contrôle 26 détermine si le signal de sortie Sₒ est saturé à l'étape 109, par exemple en reconnaissant les modes de saturations du microphone 24 par analyse des métriques du signal Sₒ ou en analysant les MFCC. Plus précisément, l'étape 109 est mise en œuvre par l'unité de détermination 34.

Si le signal de sortie Sₒ n'est pas saturé, le module électronique de contrôle 26 détermine, lors d'une étape 110, avantageusement mise en œuvre par l'unité de détermination 34, une classe d'intensité de déclenchement associée au courant de déclenchement, via un modèle d'intelligence artificielle. Le modèle d'intelligence artificielle est par exemple une forêt aléatoire, mais en variante, est un modèle de machine à vecteurs de support, ou SVM, de l'anglais « Support Vector Machine », un modèle des k plus proches voisins, ou k-NN, de l'anglais « k-Nearest Neighbours », ou encore, un réseau de neurones. Le modèle d'intelligence artificielle est préalablement entraîné par apprentissage automatique, ainsi que décrit plus en détail par la suite.

Le modèle d'intelligence artificielle prend en entrée la pluralité de métriques, et fournit, à partir de la pluralité de métriques, la classe d'intensité de déclenchement associée au courant de déclenchement. Selon un exemple, le modèle d'intelligence artificielle fournit la classe d'intensité majoritaire, la classe d'intensité de déclenchement associée au courant de déclenchement étant la classe dont la probabilité d'appartenance est la plus élevée.

La classe d'intensité de déclenchement est choisie parmi une pluralité de classes d'intensité de déclenchement, aussi dites simplement classes. Les classes d'intensité de déclenchement sont prédéterminées, par exemple par le constructeur du système 20, et chaque classe d'intensité de déclenchement correspond à une plage d'intensité de déclenchement. Par exemple, les classes d'intensité de déclenchement sont au nombre de cinq et la plage d'intensité de chaque classe est distincte de celle des autres classes. Par exemple :
- une première classe correspond à une intensité de déclenchement I_{d} nulle,
- une deuxième classe correspond à une intensité de déclenchement I_{d} comprise strictement entre 0 et 250A,
- une troisième classe correspond à une intensité de déclenchement I_{d} supérieure ou égale à 250A et strictement inférieure à 2500A,
- une quatrième classe correspond à une intensité de déclenchement I_{d} supérieure ou égale à 2500A et strictement inférieure à 5000A, et
- une cinquième classe correspond à une intensité de déclenchement I_{d} supérieure ou égale à 5000A.

La première classe et la deuxième classe correspondent en particulier à une ouverture suite à une commande de l'utilisateur, la troisième classe correspond en particulier à un déclenchement du disjoncteur 11 suite à une surcharge. Les quatrième et cinquième classes correspondent par exemple à des courts-circuits.

En variante, la pluralité de classes est formée de plus, ou de moins de cinq classes.

Si, lors de l'étape 109, le module électronique de contrôle 26, ou avantageusement, l'unité de détermination 34, détermine que le signal de sortie Sₒ est saturé, alors il attribue directement au courant de déclenchement une classe d'intensité de déclenchement dite maximale lors d'une étape 112. La classe d'intensité maximale correspond à la classe dont la plage d'intensité est la plus élevée. Par exemple, dans le cas des cinq classes décrites ci-dessus, la classe d'intensité de déclenchement maximale est la cinquième classe, correspondant à une intensité de déclenchement I_{d} supérieure à 5000A.

De manière avantageuse, le module électronique de contrôle 26 transmet la classe d'intensité de déclenchement au module d'émission 28 lors d'une étape 114. L'étape 114 est avantageusement mise en œuvre par l'unité de transmission 40. Le module d'émission 28 est par exemple connecté, via une connexion filaire, ou sans fil, par exemple via Wifi ou Bluetooth, à un terminal extérieur au système d'estimation 10, non représenté, et suite à la transmission de la classe d'intensité de déclenchement par le module électronique de contrôle, émet la classe d'intensité de déclenchement, qui est reçue par le terminale et affichée, par exemple sous la forme d'un message, sur le terminal. Par exemple, le module d'émission 28 est un boîtier Wifi ou Bluetooth. Un utilisateur ou un technicien est ainsi informé de l'intensité de déclenchement I_{d} lors du déclenchement du disjoncteur 11, ce qui lui permet avantageusement, d'évaluer la sévérité du défaut électrique ayant causé le basculement du disjoncteur 11 en configuration déclenchée, d'estimer un état du disjoncteur et/ou de planifier des opérations de maintenance prédictive, sur le disjoncteur 11 ou sur l'installation 1 de manière plus générale.

Le modèle d'intelligence artificielle est entraîné par apprentissage automatique supervisé. Par exemple, une pluralité de signaux de sortie correspondant à différentes intensités de déclenchement sont enregistrés dans une base de données. Les signaux de sortie sont ensuite avantageusement filtrés. De manière avantageuse, afin de prendre en compte une possible déformation du son généré par le disjoncteur 11, causé par des variations de températures de l'environnement dans lequel évolue le disjoncteur 11, un bruit aléatoire entre -3dB et +3dB est ajouté à chaque signal de sortie filtré, pour former une pluralité de signaux de sortie bruités. Le signal de sortie bruité est ensuite avantageusement normalisé en amplitude, puis les métriques, par exemple les MFCC sont calculées pour chaque signal de sortie bruité. Les MFCC de chaque signal de sortie bruité forment les données d'entraînement du modèle d'intelligence artificielle.

De manière avantageuse, afin d'augmenter la quantité des données d'entraînement et/ou équilibrer les données collectées entre chaque classe, des méthodes d'augmentation de données sont utilisées, comme la technique de sur-échantillonage synthétique de minorité, aussi appelé méthode SMOTE, de l'anglais « Synthetic Minority Over-Sampling Technique ». Le modèle est ensuite entraîné sur les données d'entraînement, et avantageusement, validé, par exemple par une méthode de validation croisée, ou « Cross-Validation » en anglais.

Avantageusement, en particulier dans le cas où le modèle d'intelligence artificielle est une forêt aléatoire, le modèle est entraîné avec une méthode d'ensachage, de l'anglais « bagging ».

L'étape de normalisation 106 permet d'utiliser le même système d'estimation 20, mettant en œuvre le procédé décrit précédemment, sur des disjoncteurs différents, par exemple sur des disjoncteurs à deux pôles et sur des disjoncteurs à trois pôles.

## Revendications

1. Procédé d'estimation d'une intensité de déclenchement (I_{d}) d'un disjoncteur (11), le disjoncteur (11) étant apte à être connecté entre une source (3) et une charge (5), le disjoncteur (11) étant configuré pour basculer d'une configuration armée, dans laquelle le disjoncteur (11) conduit un courant circulant entre la source (3) et la charge (5), à une configuration déclenchée, dans laquelle le disjoncteur (11) isole électriquement la charge (3) de la source (5), un courant de déclenchement, d'intensité égale à l'intensité de déclenchement (I_{d}), circulant dans le disjoncteur (11) lorsqu'il bascule dans la configuration déclenchée, le basculement du disjoncteur (11) dans la configuration déclenchée générant un son, représentatif de l'intensité de déclenchement (I_{d}), le procédé comprenant au moins les étapes suivantes, mises en œuvre par un module électronique de contrôle (26) :
- acquisition (102) d'un signal de sortie (Sₒ) émis par un microphone (24), le signal de sortie (Sₒ) étant représentatif du son généré par le disjoncteur (11) lorsqu'il bascule dans la configuration déclenchée ;
- calcul (108) d'une pluralité de métriques à partir du signal de sortie (Sₒ) ; et
- détermination (110) d'une classe d'intensité de déclenchement via un modèle d'intelligence artificielle, préalablement entraîné par apprentissage automatique pour fournir, à partir de la pluralité de métriques, la classe d'intensité de déclenchement associée au courant de déclenchement, la classe d'intensité de déclenchement étant choisie parmi une pluralité de classes d'intensité de déclenchement prédéterminées, chaque classe d'intensité de déclenchement correspondant à une plage d'intensité de déclenchement (I_{d}).

2. Procédé selon la revendication 1, comprenant en outre une étape de filtrage (104) du signal de sortie (Sₒ).

3. Procédé selon l'une quelconque des revendications précédentes, comprenant en outre une étape de normalisation (106) pour normaliser en amplitude le signal de sortie (Sₒ).

4. Procédé selon l'une quelconque des revendications précédentes, dans lequel le calcul (108) de la pluralité de métriques comprend le calcul d'une pluralité de coefficients cepstraux sur l'échelle Mel à partir du signal de sortie (Sₒ).

5. Procédé selon l'une quelconque des revendications précédentes, dans lequel la pluralité de classes d'intensité de déclenchement est formée de cinq classes d'intensité de déclenchement, chaque classe d'intensité de déclenchement correspondant à une plage d'intensité de déclenchement (I_{d}) distincte des autres classes d'intensité de déclenchement.

6. Procédé selon l'une quelconque des revendications précédentes, dans lequel le modèle d'intelligence artificielle est une forêt aléatoire.

7. Procédé selon l'une quelconque des revendications précédentes, comprenant en outre une étape de transmission (114) de la classe d'intensité de déclenchement déterminée à un module d'émission (28).

8. Procédé selon l'une quelconque des revendications précédentes, comprenant en outre une étape d'attribution (112) d'une classe d'intensité de déclenchement dite maximale au courant de déclenchement si le microphone (24) sature lors de l'acquisition du son.

9. Système d'estimation (20) d'une intensité de déclenchement (I_{d}) d'un disjoncteur (11), le disjoncteur (11) étant apte à être connecté entre une source (3) et une charge (5), le disjoncteur (11) étant configuré pour basculer d'une configuration armée, dans laquelle le disjoncteur (11) conduit un courant circulant entre la source (3) et la charge (5), à une configuration déclenchée, dans laquelle le disjoncteur (11) isole électriquement la charge (3) de la source (5), un courant de déclenchement d'intensité l'intensité de déclenchement (I_{d}) circulant dans le disjoncteur (11) lorsqu'il bascule dans la configuration déclenchée, le basculement du disjoncteur (11) dans la configuration déclenchée générant un son, représentatif de l'intensité de déclenchement (I_{d}), le système (20) comprenant :
- un microphone (24), configuré pour acquérir le son généré par le disjoncteur (11) lorsqu'il bascule dans la configuration déclenchée et pour émettre un signal de sortie (Sₒ), le signal de sortie (Sₒ) étant représentatif du son ;
- un module électronique de contrôle (26), configuré pour recevoir le signal de sortie (Sₒ), le module électronique de contrôle (26) comprenant :
∘ une unité de calcul (32) configurée pour calculer une pluralité de métriques à partir du signal de sortie (Sₒ) ; et
∘ une unité de détermination (34), configurée pour déterminer une classe d'intensité de déclenchement via un modèle d'intelligence artificielle, préalablement entraîné par apprentissage automatique pour fournir, à partir de la pluralité de métriques, la classe d'intensité de déclenchement associée au courant de déclenchement, la classe d'intensité de déclenchement étant choisie parmi une pluralité de classes d'intensité de déclenchement prédéterminées, chaque classe d'intensité de déclenchement correspondant à une plage d'intensité de déclenchement (I_{d}) .

10. Ensemble électrique (10) comprenant :
- un disjoncteur (11), apte à être connecté entre une source (3) et une charge (5), le disjoncteur (11) étant configuré pour basculer d'une configuration armée, dans lequel le disjoncteur (11) conduit un courant circulant entre la source (3) et la charge (5), à une configuration déclenchée, dans lequel le disjoncteur (11) isole électriquement la charge (3) de la source (5), lorsqu'un courant de déclenchement d'intensité une intensité de déclenchement (I_{d}) circule dans le disjoncteur (11), le basculement du disjoncteur (11) dans la configuration déclenchée générant un son représentatif de l'intensité de déclenchement (I_{d}), le disjoncteur (11) comprenant un boîtier (12) ; et
- un système d'estimation (20) selon la revendication 9, fixé au boîtier (12).

11. Programme d'ordinateur comprenant des instructions logicielles qui, lorsqu'elles sont exécutées par un microcontrôleur, mettent en œuvre un procédé d'estimation selon l'une quelconque des revendications 1 à 8.
